# EUROPÄISCHE PATENTSCHRIFT

(11) **EP 0 407 648 B1**
(45) Veröffentlichungstag und Bekanntmachung des Hinweises auf die Patenterteilung: **30.03.1994**
(21) Anmeldenummer: 89112979.3
(22) Anmeldetag: 14.07.1989
(51) Int. Cl.: H04N 5/907, G06F 15/64

(54) **Verfahren zur Speicherung von Videosignaldaten und Vorrichtung zur Durchführung des Verfahrens**
Method and apparatus for the storage of video signal data
Procédé et appareil pour le stockage des données de signal vidéo

(43) Veröffentlichungstag der Anmeldung: 16.01.1991
(73) Patentinhaber: SIEMENS AKTIENGESELLSCHAFT, 80333 München (DE)
(72) Erfinder: Bayer, Erich, D-8050 Freising (DE); Braun, Bodo, Dr., D-8000 München 80 (DE)

(56) Entgegenhaltungen:
- TECHNISCHE MITTEILUNGEN DES RFZ Band 30, Nr. 4, December 1986, seiten 75-78, Berlin, DDR; W. ECKARDT et al.: "Digitaler Standbildspeicher für den Fernsehstudiobetrieb"

## Beschreibung

Die Erfindung betrifft ein Verfahren zur Speicherung von Videosignaldaten nach dem Oberbegriff des Anspruchs 1 sowie eine Vorrichtung zur Durchführung dieses Verfahrens. Der Oberbegriff basiert auf "Technische Mitteilungen des RFZ 30(1986) Dez., No.4, Berlin, DDR

Die Speicherung von Videosignaldaten gewinnt zunehmend an Bedeutung. Aus Siemens Components 26, 1988, Heft 6, Seite 240 bis 245 ist beispielsweise ein digitales Fernsehkonzept bekannt, dessen zentraler Bestandteil eine Speichereinrichtung zum Speichern von Videosignaldaten des Fernsehbildes ist. Dank dieser Speichereinrichtung ist es beispielsweise möglich, die ankommenden Videosignaldaten in die Speichereinrichtung einzuschreiben und mit doppelter Geschwindigkeit zweimal auszulesen. Dadurch verdoppeln sich die Vertikal- und Horizontal-Frequenzen, wodurch das bisher bekannte Großflächenflimmern am Bildschirm vollständig beseitigt werden kann. Mit der Speichereinrichtung ist es unter anderem auch möglich Rauschunterdrückung, Cross-color-Verminderung und Features wie Bild-im-Bild, tueunfachbild und Zoom bei Fernsehempfängern vorzusehen.

Bei den heutigen Speicheranwendungen für Videosignale werden Abtastraster mit b Punkten je Zeile und z Zeilen verwendet, wobei b und z im allgemeinen keine Zweierpotenzen sind. Dennoch werden diese Daten so gespeichert, daß eine getrennte Adressierung der Bildpunkte und Bildzeilen durch Adreßzähler möglich ist. Folgende Speicherrealisierungen sind denkbar:
a) Verwendung von Spezialspeicherbausteinen mit an das Abtastraster des Videosignals angepaßter Zeilen- und Spaltenorganisation;
b) Verwendung von Standardspeicherbausteinen unter Inkaufnahme einer zu großen Speicherkapazität und
c) Reduzierung der Bildinformation auf ein der Speicherorganisation von Standardspeicherbausteinen zugeschnittenes Format.

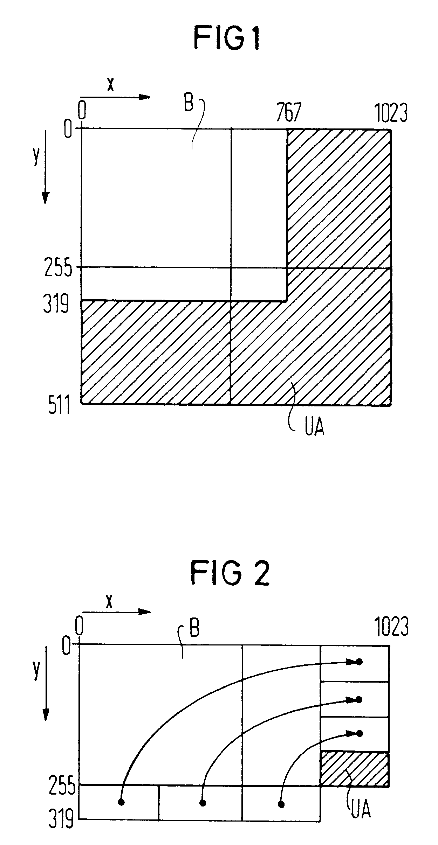

Während die Verwendung von Spezialspeicherbausteinen mit an das Abtastraster angepaßten Zeilen- und Spaltenorganisation extra für die Videosignaldatenspeicherung angepaßte Speicherbausteine, die damit teuer sind, benötigt, ist die unter c vorgeschlagene Lösung zwar insofern vorteilhaft, als Standardspeicherbausteine verwendet werden können. Jedoch muß die Bildinformation auf die Speicherorganisation dieses Standardspeicherbausteines zugeschnitten werden, womit sich gezwungenermaßen eine Reduzierung der Bildinformation ergibt. Sollen jedoch Standardspeicherbausteine verwendet und keine Reduzierung der Bildinformation in Kauf genommen werden, so ist es bisher lediglich möglich, Standardspeicherbausteine mit zu großer Speicherkapazität einzusetzen. Dies ist beispielhaft in FIG 1 dargestellt, in der ein zu speicherndes Bild B mit 768 Bildpunkten und 320 Bildzeilen angenommen ist. Zur Speicherung dieses Bildes B müssen bei getrennter Bildpunkt- und Zeilenadressierung ein oder mehrere Standardspeicherbausteine eingesetzt werden, die insgesamt eine Organisation des Speichers mit 1024 Spalten und 512 Zeilen aufweist. Der ungenutzte Adreßbereich UA ist beträchtlich und in FIG 1 schraffiert gezeichnet.

Der Erfindung liegt deshalb die Aufgabe zugrunde, ein Verfahren zur Speicherung von Videosignaldaten und eine Vorrichtung zur Durchführung des Verfahrens anzugeben, mit dem eine bessere Ausnutzung des physikalischen Speicherplatzes von Standardspeicherbausteinen erzielt wird.

Diese Aufgabe wird für das Verfahren durch die Merkmale des Anspruchs 1 gelöst.

Weiterbildungen des erfindungsgemäßen Verfahrens sind Gegenstand der abhängigen Verfahrensansprüche.

Eine Vorrichtung zur Durchführung des erfindungsgemäßen Verfahrens ist Gegenstand des Anspruches 10.

Eine bevorzugte Weiterbildung dieser Vorrichtung ist Gegenstand des Anspruchs 11.

Das erfindungsgemäße Verfahren zur Speicherung von Videosignaldaten beruht also darauf, die x Adreßbits für die Bildpunkte und die y Adreßbits für die Zeilen mindestens teilweise so umzucodieren, daß unter Berücksichtigung der bei Videosignalen sinnvollen Zeilenzahlen und Bildpunkten je Zeile eine möglichst vollständige Ausnutzung des Speichervolumens von Standardspeicherbausteinen erzielt wird. Da die Bildpunkte und Zeilen kleiner als eine Zweierpotenz gewählt sind, kann unter Ausnutzung der nichtauftretenden Bitkombinationen der Bildadressen jeder Bildadresse eine eigene Speicheradresse eindeutig zugeordnet werden.

Die Erfindung wird im folgenden anhand von weiteren neun Figuren ausführlich beschrieben. Es zeigen:
- FIG 2: eine prinzipielle Darstellung des erfindungsgemäßen Verfahrens bei einem zu speicherndem Bild nach FIG 1,
- FIG 3: eine mögliche Adreßumcodierung nach FIG 2,
- FIG 4: eine Abbildungsmatrix zur Durchführung der Umcodierung nach FIG 2 und 3,
- FIG 5: eine Umcodiereinrichtung nach FIG 3 und 4 mit von einem Bildadreßbit gesteuerten Multiplexern,
- FIG 6: eine mögliche Adreßumcodierung bei der Speicherung von Bildern mit 288 Zeilen und 896 Bildpunkten,
- FIG 7: eine mögliche Abbildungsmatrix nach FIG 6,
- FIG 8: eine Umcodiereinrichtung nach FIG 7 mit von einem Bildadreßbit gesteuerten Multiplexern,
- FIG 9: eine Darstellung von seriell multiplexten Videosignaldaten, die in einem 4 : 1 : 1 Adreßformat vorliegen und
- FIG 10: das Blockschaltbild einer erfindungsgemäßen Schaltungseinrichtung zur Speicherung von Videosignaldaten.

In FIG 2 ist das erfindungsgemäße Verfahren zur Speicherung von Videosignaldaten für einen Standardspeicherbaustein mit 2^{m} möglichen Speicheradressen beispielhaft dargestellt. Wird angenommen, daß ein Teilbild oder Vollbild B wie in FIG 1 gespeichert werden soll, also 768 Bildpunkte und 320 Bildzeilen, so muß gemäß der Erfindung 2^{m} klein wie möglich, jedoch größer als das Produkt aus der Anzahl der Bildpunkte und der Anzahl der Bildzeilen gewählt werden. Da das Produkt aus der Anzahl der Bildpunkte b und der Anzahl der Bildzeilen z gleich 245760 ist, muß erfindungsgemäß m = 18 gewählt werden. Damit wird ein Speicherbaustein mit 2¹⁸ = 262144 möglichen Speicheradressen notwendig. Dieser Standardspeicherbaustein ist zweckmäßigerweise in 1024 Spalten und 256 Zeilen organisiert.

Da in diesem Ausführungsbeispiel eine getrennte Adressierung der 768 Bildpunkte durch 10 Adreßbits für die 768 Spaltenadressen im Bild und der 320 Zeilen durch 9 Adreßbits für die 320 Zeilenadressen im Bild notwendig ist und die Anzahl der Bildpunkte kleiner als 2¹⁰ und die Anzahl der Zeilen kleiner als 2⁹ ist, ist es erfindungsgemäß möglich, die 10 Adreßbits und 9 Adreßbits unter Ausnutzung der nicht auftretenden Bitkombinationen derart umzucodieren, daß jeder Bildadresse eine eigene Speicheradresse des Standardspeichers zugeordnet wird. Schematisch ist dies in FIG 1 dadurch dargestellt, daß die Videosignaldaten ab der 256. Zeile in den bis dahin noch nicht benutzten Speicherplatz des Standardspeicherbausteines eingeschrieben werden, also in den noch freien Speicherraum ab der 768. Spalte. Der letztlich nicht benutzte Speicherplatz UA ist in FIG 2 wieder schraffiert gekennzeichnet. Ein Vergleich des schraffierten ungenutzten Adreßbereiches in FIG 1 und FIG 2 zeigt deutlich, daß durch die Umcodierung der Bildadressen eine bessere und damit effiziente Ausnutzung des Speicherplatzes von Standardspeicherbausteinen möglich ist. Im Vergleich zu FIG 1 ist damit in FIG 2 ein Standardspeicherbaustein oder Standardspeicherbausteine mit halber Speicherkapazität zur Bildspeicherung ausreichend.

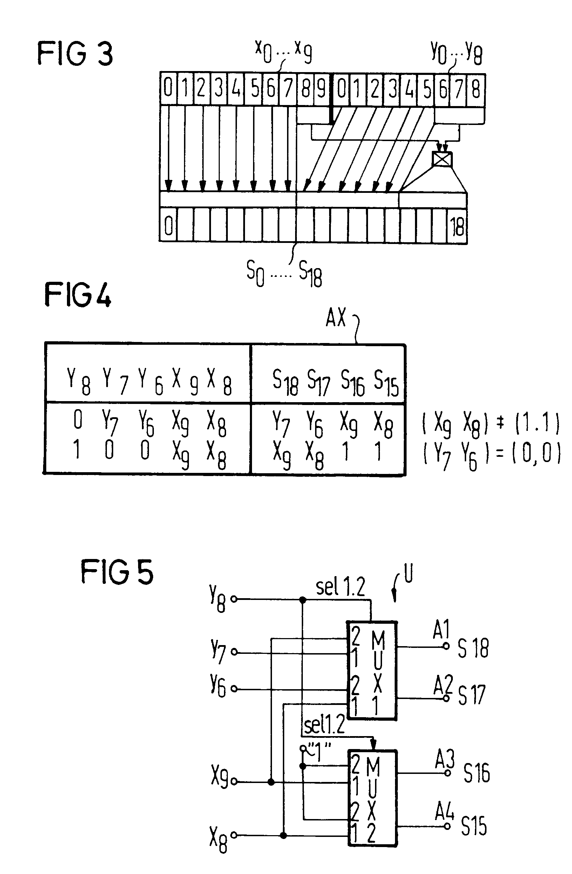

In FIG 3 ist eine mögliche Adreßumcodierung für das in FIG 2 dargestellte Ausführungsbeispiel gezeigt. Die Umcodierung der x Adreßbits x₀...x₉ und y Adreßbits y₀...y₈ erfolgt unter Ausnutzung der nicht auftretenden Bitkombinationen der Bildadressen. Wie im Zusammenhang mit FIG 4 noch zu erläutern sein wird, erfolgt die Umcodierung der x Adreßbits und y Adreßbits nur für einen Teil der x Adreßbits und einen Teil der y Adreßbits. In diesem Ausführungsbeispiel werden die zwei Adreßbits x₈ und x₉ der x Adreßbits und die drei Adreßbits y₆, y₇ und y₈ der y Adreßbits zu vier Adreßbits s₁₅, s₁₆, s₁₇ und s₁₈ der Speicheradressen s₀...s₁₈ umcodiert. Die Speicheradreßbits s₀ bis s₇ entsprechen den Bildadreßbits x₀ bis x₇ und die Speicheradreßbits s₈ bis s₁₄ entsprechen den Bildadreßbits bis y₀ bis y₅, wie in FIG 3 durch verbindende Linien dargestellt. Damit sind die aus insgesamt 19 Bit bestehenden Bildadressen zu 18-Bit-Speicheradressen umcodiert.

In FIG 4 ist eine mögliche Abbildungsmatrix AX zur Durchführung des erfindungsgemäßen Verfahrens für ein Bild nach FIG 2 und FIG 3 gezeigt. Da das Bild bzw. Teilbild lediglich 768 Bildpunkte aufweist, steht fest, daß die Adreßbits x₈ und x₉ nie gleichzeitig eins werden können. Für die y Adreßbits zur Bildzeilenadressierung gilt, daß bei einem auftretenden Adreßbit y₈ = 1 die übrigen y Adreßbits y₀ bis y₇ immer kleiner gleich 63 sein müssen. Damit stehen die Adreßbits y₇ und y₆, die gleich 0 sein müssen, der y Adreßbits frei zur Verfügung und können für die Adreßbits x₉ und x₈ verwendet werden. Die dabei entstehende Abbildungsmatrix AX ist in FIG 4 anhand ihrer Abbildungsvorschrift dargestellt.

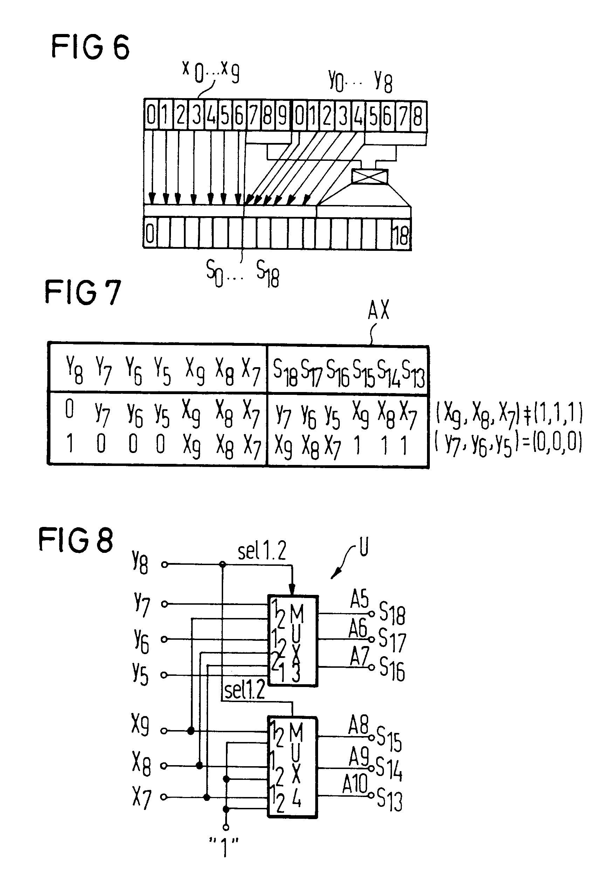

In FIG 5 ist eine Umcodiereinrichtung U gemäß der in FIG 4 beschriebenen Abbildungsmatrix AX dargestellt. Diese Umcodiereinrichtung U weist vom Adreßbit y₈ gesteuerte erste Multiplexer MUX1 und zweite Multiplexer MUX2 auf. Die ersten und zweiten Multiplexer MUX1, MUX2 weisen jeweils zwei vom Adreßbit y₈ steuerbare Umschalter auf, an deren Ausgangsklemmen A1 bis A4 die Adreßbits s18 bis s15 der Speicheradressen abgreifbar sind. Die Eingangsklemmen der ersten Multiplexer MUX1 und zweiten Multiplexer MUX2 sind gemäß der Abbildungsmatrix in FIG 4 mit Leitungen für die Adreßbits y₈, y₇, y₆, x₉ und x₈ in Verbindung bzw. auf logisch 1 gelegt. Ist das Adreßbit y₈ beispielsweise 0, so steht an der ersten Ausgangsklemme A1 der Umcodiereinrichtung das Speicheradreßbit S₁₈ an, das dem Adreßbit y₇ entspricht. Ist das Adreßbit y₈ jedoch 1, so steht an der Ausgangsklemme A1 der dem Adreßbit x₉ entsprechende logische Wert an usw..

Bei Kenntnis der in FIG 4 dargestellten Abbildungsmatrix AX bereitet diese schaltungstechnische Realisierung jedoch dem Fachmann keinerlei Schwierigkeiten, so daß auf deren detaillierte Darstellung in diesem Zusammenhang verzichtet wird.

In den nachfolgenden Figuren 6, 7 und 8 wird das erfindungsgemäße Verfahren anhand eines zu speichernden Bildes mit 288 Bildzeilen und 896 Bildpunkten beschrieben. Erfindungsgemäß muß demnach m = 18 gewählt werden. Damit kann der gleiche Speicherbaustein wie in FIG 2 beschrieben, eingesetzt werden. Eine mögliche Umcodierung der Bildadressen ist in FIG 6 dargestellt. Es bietet sich eine Umcodierung der Adreßbits x₇, x₈, x₉ sowie der Adreßbits y₅, y₆, y₇ und y₈ an. Diese sieben Adreßbits werden zu sechs Speicheradreßbits s₁₃ bis s₁₈ umcodiert.

Die Abbildungsmatrix AX dazu ist in FIG 7 zu sehen. Folgende Informationen über die Bildadressen werden dabei ausgenutzt: Die Adreßbits x₉, x₈ und x₇ können niemals gleichzeitig 1 werden. Wenn das Adreßbit y₈ gleich 1 ist, dann sind die Adreßbits y₇, y₆ und y₅ gleich 0. Daher können die Adreßbits y₇, y₈ und y₅ für die Adreßbits x₉, x₈ und x₇ verwendet werden. Die sich dabei ergebende Abbildungsmatrix AX weist die in FIG 7 dargestellte Abbildungsvorschrift auf.

In FIG 8 ist eine mögliche Umcodiereinrichtung für die Abbildungsmatrix AX nach FIG 7 dargestellt. Diese Umcodiereinrichtung U weist einen dritten Multiplexer MUX3 und einen vierten Multiplexer MUX4 auf, die jeweils drei Ausgangsklemmen A₅, A₆, A₇ und A₈, A₉ und A₁₀ auf, an denen die Speicheradreßbits s₁₈ bis s₁₃ abgreifbar sind. Der dritte Multiplexer MUX3 und vierte Multiplexer MUX4 verfügt jeweils über drei Umschalteinrichtungen, die vom Adreßbit y₈ - je nach dessen logischen Wert - umschalten. An den ersten Eingangsklemmen des ersten Umschalters des dritten Multiplexers MUX3 ist das Adreßbit y₇ und das Adreßbit x₉ geschaltet. An den Eingangsklemmen eines zweiten Umschalters des dritten Multiplexers MUX3 sind die Adreßbits y₆ und x₈ geschaltet, während die Eingangsklemmen der dritten Umschalteinrichtung des dritten Multiplexers MUX3 mit den Adreßbits y₅ und x₇ verbunden sind. Die Adreßbits x₉, x₈, und x₇ sind an jeweils eine Eingangsklemme der drei Umschalteinrichtungen des vierten Multiplexers MUX4 geschaltet, an deren anderen Eingangsklemmen eine logische 1 anlegbar ist. Wenn das Adreßbit y₈ logisch 0 ist, entsprechen die an den Ausgangsklemmen A1 bis A6 der Umcodiereinrichtung U von FIG 8 abgreifbaren Speicheradressen s₁₈ bis s₁₃ den Adreßbits y₇, y₆, y₅, x₉, x₈ und x₇. Ist dagegen das die Steuerung der Umschalter bewirkende Adreßbit y₈ logisch 1, so werden die Speicheradreßbits s₁₃, s₁₄ und s₁₅ = 1 und die Speicheradreßbits s₁₆, s₁₇, s₁₈ zu x₇, x₈ und x₉. Damit ist eine eindeutige Umcodierung der Bildadressen zu den Speicheradressen erreicht. Da dieselbe Abbildungsmatrix so wohl zum Einschreiben als auch zum Auslesen der Videosignaldaten bzw. aus dem Standardspeicher benutzt werden kann, ist die Realisierung der inversen Abbildungsmatrix, die die Speicheradressen auf die Bildadressen abbildet nicht notwendig.

Mit diesem erfindungsgemäßen Umcodieren der Bildadressen zu Speicheradressen ist es in einfacher Weise möglich, Standardspeicherbausteine effizient zu nutzen. Um die Abbildungsmatrix möglichst einfach zu gestalten, ist es zweckmäßig aber nicht unbedingt notwendig, die Anzahl der Bildpunkte und Bildzeilen als Differenz oder Summe von Zweierpotenzen zu wählen, wie dies in den vorgenannten Beispielen der Fall war (768 = 2¹⁰-2⁸; 320 = 2⁸ + 2⁶; 896 = 2¹⁰ - 2⁷ und 288 = 2⁸ + 2⁵). Andere Realisierungen können jedoch auch beispielsweise 928 x-Adressen und 282 y-Adressen vorsehen.

Eine weitere Ausführungsform der Erfindung sieht vor, die Videosignaldaten bitebenenverschachtelt in den Standardspeicherbaustein einzuschreiben. Dies ist für die effiziente Ausnutzung des physikalischen Speicherraumes insbesondere dann von Vorteil, wenn die Datenwortbreite der Videosignaldaten nicht mit der Speicherwortbreite des Standardspeicherbausteins übereinstimmt. Sind die Videosignaldaten beispielsweise in Datenworte zu 7 Bit organisiert und weist der Standardspeicher 8-Bit-Speicherworte auf, so werden 9 mal 7 Bitdatenworte in 8 mal 8 Bitspeicherworte eingeschrieben. Allgemein läßt sich sagen, daß zur effizienten Ausnutzung des physikalischen Speicherraumes die Anzahl der Speicherworte pro Zeile in etwa aus der Anzahl von Datenworten pro Zeile multipliziert mit dem Verhältnis aus Datenwortbreite und Speicherwortbreite gewählt wird.

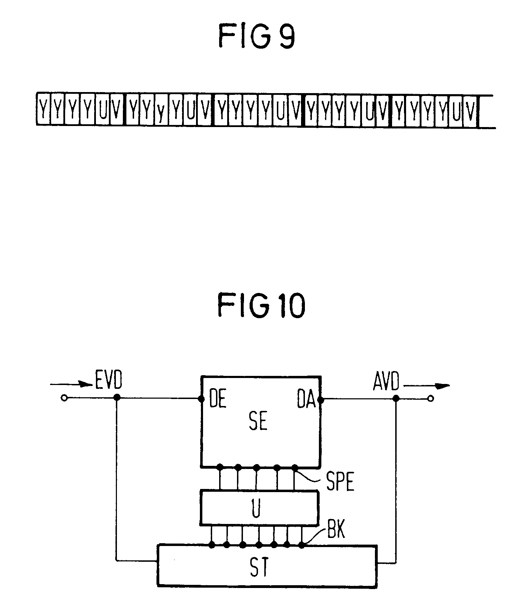

Liegen die Videosignaldaten als seriell multiplexte Komponenten vor, z. B. als YUV-Signal (Y = Luminanz, UV Chrominanz), so kann das erfindungsgemäße Verfahren ebenfalls angewendet werden. Ein mögliches und in FIG 9 dargestelltes Adreßformat ist beispielsweise 4 : 1 : 1, d. h. daß die Abtastfrequenz für das Luminanzsignal Y viermal höher als die Abtastfrequenz für die Chrominanzsignale U und V gewählt sind. Die Abtastfrequenz für das Luminanzsignal Y kann beispielsweise 13,5 Mhz und für die Chrominanzsignale U und V 3,375 Mhz betragen. Für die Komponenten Y, U und V kann ein gemeinsamer Speicher verwendet werden oder aber separate Speicher. In diesem Fall reicht bei einer Auflösung von 7 Bit je Komponente ein Speicher mit insgesamt 2 Mbit aus.

In FIG 10 ist das Prinzipschaltbild einer Schaltungsanordnung zur Durchführung des erfindungsgemäßen Verfahrens dargestellt. Die Schaltungsanordnung weist mindestens eine Speichereinrichtung SE mit Speicheradreßeingangsklemmen SPE zur Adressierung von 2^{m} möglichen Speicheradressen, eine Dateneingangsklemme DE sowie eine Datenausgangsklemme DA auf. Die zu speichernden Videosignaldaten EVD gelangen über eine Zuleitung an die Dateneingangsklemme DE der Speichereinrichtung SPE. Die aus der Speichereinrichtung SE auslesbaren Videosignaldaten AVD sind an der Datenausgangsklemme DA abgreifbar. Über eine Steuereinrichtung ST ist die Speicherung der Videosignaldaten EVD sowie das Auslesen der gespeicherten Daten möglich. Dazu werden von der Steuereinrichtung ST den Videosignaldaten EVD Bildadressen zugeordnet, die an Bildadreßklemmen BK abgreifbar sind. Diese Bildadressen bestehen aus x Adreßbits für die Spaltenadressen im Bild und davon getrennten y Adreßbits für die Zeilenadressen im Bild. Beim Einlesen der Videosignaldaten EVD in die Speichereinrichtung SE werden diesen über die Steuereinrichtung ST die dazugehörenden Bildadressen zugeordnet. Über eine Umcodiereinrichtung U, die im Zusammenhang mit den Figuren 5 und 8 bereits eingehend erläutert wurde, kann jeder Bildadresse eindeutig eine eigene Speicheradresse zugeordnet werden. Dazu ist die Umcodiereinrichtung U zwischen die Bildadreßklemmen BK und Speicheradreßeingangsklemmen SPE geschaltet. Ausgelesen werden die gespeicherten Videosignaldaten dadurch, daß den gespeicherten Videosignaldaten wiederum Bildadressen zugeordnet, diese in Speicheradressen umcodiert und schließlich taktrichtig ausgelesen werden.

## Patentansprüche

1. Verfahren zur Speicherung von Videosignaldaten mindestens eines Teilbildes in Standardspeicherbausteinen mit 2^{m} möglichen Speicheradressen, wobei über Bildadressen b Bildpunkte durch x Adreßbits und z Zeilen durch y Adreßbits getrennt adressiert werden mit der Bedingung, daß b < 2^{x} und z < 2^{y} ist und m, b, z, x und y positive ganze Zahlen sind, wobei 2^{m} so klein wie möglich, jedoch großer als das Produkt aus b und z gewählt wird und die x Adreßbits und y Adreßbits unter Ausnutzung der nicht auftretenden Bitkombinationen der Bildadressen umcodiert werden, so daß jeder auftretenden Bildadresse eine eigene Speicheradresse zugeordnet ist,
**dadurch gekennzeichnet,**
daß nur ein Teil der x-Adreßbits und nur ein Teil der y-Adreßbits umcodiert wird,
daß die übrigen nicht umcodierten x-Adreßbits und y-Adreßbits ohne Umcodierung direkt Speicheradreßbits zugeordnet werden, und
daß ein x-Adreßbit oder y-Adreßbit diese Umcodierung steuert.

2. Verfahren nach Anspruch 1,
**dadurch gekennzeichnet,**
daß die Umcodierung mit einer Abbildungsmatrix durchgeführt wird.

3. Verfahren nach einem der Ansprüche 1 bis 2,
**dadurch gekennzeichnet,**
daß die Videosignaldaten seriell multiplext werden.

4. Verfahren nach einem der Ansprüche 1 bis 3,
**dadurch gekennzeichnet,**
daß mindestens 768 Bildpunkte je Zeile und mindestens 288 Zeilen gespeichert werden.

5. Verfahren nach einem der Ansprüche 1 bis 4,
**dadurch gekennzeichnet,**
daß ein Halbbild gespeichert wird.

6. Verfahren nach einem der Ansprüche 1 bis 5,
**dadurch gekennzeichnet,**
daß ein Vollbild gespeichert wird.

7. Verfahren nach einem der Ansprüche 1 bis 6,
**dadurch gekennzeichnet,**
daß die Videosignaldaten bitebenenverschachtelt gespeichert werden, wobei die Anzahl von Speicherworten pro Zeile in etwa aus der Anzahl von Datenworten pro Zeile multipliziert mit dem Verhältnis aus Datenwortbreite und Speicherwortbreite gewählt wird.

8. Schaltungsanordnung zur Durchführung des Verfahrens nach einem der Ansprüche 1 bis 7,
**gekennzeichnet** durch
- eine Speichereinrichtung (SE) mit Speicheradreßeingangsklemmen (SPE) zur Adressierung von 2^{m} möglichen Speicheradressen, einer Dateneingangsklemme (DE) sowie einer Datenausgangsklemme (DA),
- eine Steuereinrichtung (ST), die den Videosignaldaten an Bildadreßklemmen (BK) abgreifbare Bildadressen, bestehend aus getrennten x Adreßbits zur Bildpunktadressierung und zweiten y Adreßbits zur Zeilenadressierung, zuordnet und die Speicherung der Videosignaldaten steuert,
- eine Umcodiereinrichtung (U), die zwischen die Bildadreßklemmen (BK) und Speicheradreßeingangsklemmen (SPE) geschaltet ist und durch die jeder Bildadresse eindeutig eine eigene Speicheradresse zuzuordnen ist und
- Mittel zum Auslesen der Videosignaldaten aus der Speichereinrichtung (SE),
und daß die Schaltungsanordnung so ausgebildet ist, daß nur ein Teil der x-Adreßbits und nur ein Teil der y-Adreßbits umcodiert wird,
daß die übrigen nicht umcodierten x-Adreßbits und y-Adreßbits ohne Umcodierung direkt Speicheradreßbits zugeordnet werden, und
daß ein x-Adreßbit oder y-Adreßbit diese Umcodierung steuert.

9. Schaltungsanordnung nach Anspruch 8,
**dadurch gekennzeichnet,**
daß die Umcodiereinrichtung (U) von mindestens einem Bit der Bildadressen gesteuerten Multiplexer (MUX1, MUX2; MUX3, MUX4) aufweist.

## Claims

1. Method for storing video signal data of at least a partial frame in standard memory chips having 2^{m} possible memory addresses, b pixels being addressed by x address bits and z lines being addressed by y address bits separately via frame addresses, with the condition that b < 2^{x} and z < 2^{y} and m, b, z, x and y are positive integers, 2^{m} being selected to be as small as possible but greater than the product of b and z and the x address bits and y address bits being recoded, utilizing the bit combinations not occurring in the frame addresses in such a manner that a separate memory address is allocated to each frame address occurring, characterized in that only some of the x address bits and only some of the y address bits are recoded, in that the remaining x address bits and y address bits not recoded are directly allocated without recoding to memory address bits, and in that this recoding is controlled by an x address bit or y address bit.

2. Method according to Claim 1, characterized in that the recoding is carried out with a mapping matrix.

3. Method according to one of Claims 1 to 2, characterized in that the video signal data are serially multiplexed.

4. Method according to one of Claims 1 to 3, characterized in that at least 768 pixels per line and at least 288 lines are stored.

5. Method according to one of Claims 1 to 4, characterized in that a field is stored.

6. Method according to one of Claims 1 to 5, characterized in that a frame is stored.

7. Method according to one of Claims 1 to 6, characterized in that the video signal data are stored multiplexed at bit level, the number of memory words per line being selected approximately from the number of data words per line multiplied by the ratio of data word length and memory word length.

8. Circuit arrangement for carrying out the method according to one of Claims 1 to 7, characterized by
- a memory device (SE) with memory address input terminals (SPE) for addressing 2^{m} possible memory addresses, a data input terminal (DE) and a data output terminal (DA),
- a control device (ST) which allocates to the video signal data frame addresses, which can be picked up at frame address terminals (BK) and consist of separate x address bits for pixel addressing and second y address bits for line addressing, and controls the storage of the video signal data,
- a recoding device (U) which is connected between the frame address terminals (BK) and memory address input terminals (SPE) and by means of which a separate memory address is to be allocated unambiguously to each frame address, and
- means for reading the video signal data out of the memory device (SE),
and in that the circuit arrangement is constructed in such a manner that only some of the x address bits and only some of the y address bits are recoded,
in that the remaining x address bits and y address bits not recoded are directly allocated without recoding to memory address bits, and in that this recoding is controlled by an x address bit or y address bit.

9. Circuit arrangement according to Claim 8, characterized in that the recoding device (U) exhibits multiplexers (MUX1, MUX2; MUX3, MUX4) controlled by at least one bit of the frame addresses.

## Revendications

1. Procédé de mémorisation de données de signaux vidéo d'au moins une image partielle, dans des modules de mémorisation standard à 2^{m} adresses de mémorisation possibles, du type dans lequel, par l'intermédiaire des adresses d'image, b points d'image sont adressés en étant séparés par x bits d'adresse et z lignes sont adressées en étant séparées par y bits d'adresse, suivant la condition b < 2^{x} et z < 2^{y}, m, b, z, x et y étant des nombres entiers positifs, du type dans lequel 2^{m} est aussi petit que possible mais est cependant choisi supérieur au produit de b et de z, et du type dans lequel les x bits d'adresse et les y bits d'adresse sont recodés, moyennant l'utilisation des combinaisons de bits des adresses d'image qui n'apparaissent pas, de telle sorte qu'à chaque adresse d'image qui apparait est associée une adresse de mémoire propre,
caractérisé par le fait :
- que l'on recode uniquement une partie des bits d'adresse-x et uniquement une partie des bits d'adresse-y,
- que l'on associe le reste des bits d'adresse-x et des bits d'adresse-y non recodés, directement et sans recodage, à des bits d'adresse de mémoire,
- et qu'un bit d'adresse-x ou un bit d'adresse-y commande ce recodage.

2. Procédé suivant la revendication 1, caractérisé en ce que l'on effectue le recodage avec une matrice d'image.

3. Procédé suivant l'une des revendications 1 à 2, caractérisé en ce que les données de signaux vidéo sont multiplexées en série.

4. Procédé suivant l'une des revendications 1 à 3, caractérisé en ce que l'on mémorise au moins 768 points d'image par ligne et au moins 288 lignes.

5. Procédé suivant l'une des revendications 1 à 4, caractérisé en ce que l'on mémorise une demi-image.

6. Procédé suivant l'une des revendications 1 à 5, caractérisé en ce que l'on mémorise une image entière.

7. Procédé suivant l'une des revendications 1 à 6, caractérisé en ce que l'on mémorise les données de signaux vidéo avec imbrication au niveau des plans de bits, le nombre de mots de mémoire par ligne étant choisi environ égal au nombre de mots de données par ligne multiplié par le rapport entre la largeur du mot de données et la largeur du mot de mémoire.

8. Montage pour la mise en oeuvre du procédé suivant l'une des revendications 1 à 7, caractérisé par :
- un dispositif de mémorisation (SE) comportant des bornes d'entrée d'adresse de mémoire (SPE) pour l'adressage de 2^{m} adresses de mémoire possibles et comportant une borne d'entrée de données (DE) ainsi qu'une borne de sortie de données (DA),
- un dispositif de commande (ST), qui affecte aux données de signaux vidéo des adresses d'image qui peuvent être prélevées aux bornes d'adresse d'image (BK) et qui sont constituées de bits d'adresse-x séparés et destinés à l'adressage des points d'image, et de deux bits d'adresse-y destinés à l'adressage des lignes, et qui commande la mémorisation des données signaux vidéo,
- un dispositif de recodage (U) qui est branché entre les bornes d'adresse d'image (BK) et les bornes d'entrée d'adresse de mémoire (SPE), et par l'intermédiaire duquel à chaque adresse d'image est associée de manière distincte une adresse de mémoire propre et,
- des moyens de lecture des données des signaux vidéo à partir du dispositif de mémorisation (SE), et
par le fait que le montage est agencé de telle sorte qu'uniquement une partie des bits d'adresse-x et uniquement une partie des bits d'adresse-y sont recodées, que les autres bits d'adresse-x et les autres bits d'adresse-y non recodés sont associés directement et sans recodage à des bits d'adresse de mémoire et qu'un bit d'adresse-x ou un bit d'adresse-y commande ce recodage.

9. Montage suivant la revendication 8, caractérisé en ce que le dispositif de recodage (U) comporte des multiplexeurs (MUX1, MUX2 ; MUX3, MUX4) qui sont commandés par au moins un bit des adresses d'image.
